(19) Europäisches Patentamt
European Patent Office
Office européen des brevets

(11) **EP 3 719 514 A1**

(12) **EUROPEAN PATENT APPLICATION**

(43) Date of publication:
07.10.2020 Bulletin 2020/41

(51) Int Cl.:
*G01R 31/34* (2020.01)    *G01R 19/25* (2006.01)

(21) Application number: 20157594.1

(22) Date of filing: 17.02.2020

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: 04.04.2019 JP 2019071859

(71) Applicant: **Hitachi, Ltd.**
**Tokyo 100-8280 (JP)**

(72) Inventors:
• **KATO, Tetsuji**
**Tokyo, 100-8280 (JP)**
• **KUBO, Akari**
**Tokyo, 100-8280 (JP)**

• **KOJIMA, Hiroaki**
**Tokyo, 100-8280 (JP)**
• **IWAJI, Yoshitaka**
**Tokyo, 100-8280 (JP)**
• **UEMURA, Takuya**
**Tokyo, 100-8280 (JP)**
• **KASUYA, Shouichi**
**Tokyo, 100-8280 (JP)**
• **TAKAYAMA, Naoya**
**Tokyo, 100-8280 (JP)**
• **MATSUMOTO, Atsushi**
**Tokyo, 100-8280 (JP)**

(74) Representative: **MERH-IP Matias Erny Reichl Hoffmann**
**Patentanwälte PartG mbB**
**Paul-Heyse-Strasse 29**
**80336 München (DE)**

(54) **DIAGNOSTIC APPARATUS**

(57)    A diagnostic apparatus includes: a waveform extracting unit which extracts a partial waveform which is a waveform having a value periodically for each of a plurality of phases from a measured waveform which is a signal from a sensor mounted on equipment which is an object to be diagnosed; a peak detecting unit which detects a peak in a change of the amplitude of the partial waveform with respect to the phase from the partial waveform for each of the plurality of phases which are converted into spectra in a frequency domain; and a diagnosis unit for diagnosing a state of the equipment which is an object to be diagnosed based on a value of the amplitude at the peak.

*FIG. 2*

EP 3 719 514 A1

**Description**

BACKGROUND OF THE INVENTION

1. Field of the Invention

The present invention relates to a diagnostic apparatus, and more particularly to equipment which diagnoses a deterioration state of equipment which is an object to be diagnosed.

2. Description of the Related Art

When a failure suddenly occurs in particular equipment of a production facility, a repair operation or a replacement operation which is not scheduled in advance becomes necessary. An operation efficiency of the production facility is also lowered or rescheduling of a production plan becomes necessary. To cope with such a state, a replacement part is preliminarily prepared with respect to a device where possibility of the occurrence of a failure is high by checking a symptom of the failure. Further, if a schedule of repair can be planed, lowering of operation efficiency of a production facility and rescheduling of a production plan can be suppressed to a minimum. Such understanding is also applicable to a case where equipment or an apparatus of a production facility is a rotary machine such as a motor (electric motor) or a generator.

A sudden failure of a rotary machine system (a system which includes a rotary machine and equipment attached to the rotary machine (for example, a power converter, gears, couplings, and a load device)) can be prevented in advance to some extent by checking the increase of an effective value of vibration by mounting a vibration sensor on each part of the rotary machine system or the increase of a component of a characteristic frequency of vibration (a frequency component determined corresponding to deterioration) and by diagnosing a deterioration state of each part. To effectively prevent the occurrence of a sudden failure, it is necessary to enhance accuracy of diagnosis of a deterioration state.

JP 2017-194368 A discloses, as an example of an apparatus which can enhance diagnosis accuracy of a deterioration state of a rotary machine system, an apparatus which can enhance accuracy of abnormality diagnosis by making use of information on a rotation phase of a rotary machine system.

SUMMARY OF THE INVENTION

Such a conventional diagnostic apparatus has a drawback that the degree of abnormality is overestimated or underestimated. For example, when a plurality of deteriorated parts exist, depending on relative positions of the deteriorated parts, there is a possibility that the plurality of deteriorated parts are determined as one deteriorated part, and the degree of abnormality is overestimated or underestimated. Also with respect to the apparatus described in JP 2017-194368 A, depending on the positions and the number of deteriorated parts such as scratches, wear or the like corresponding to a rotation phase of the rotary machine system, there may be a case where the degree of abnormality is overestimated or underestimated. When the degree of abnormality is overestimated or underestimated, such evaluations bring about an erroneous report or omission of a report. Accordingly, the conventional diagnostic apparatus has a drawback that it is necessary to enhance accuracy of diagnosis of a deterioration state of equipment which is an object to be diagnosed.

It is an object of the present invention to provide a diagnostic apparatus capable of diagnosing a deterioration state of equipment which is an object to be diagnosed with high accuracy.

A diagnostic apparatus according to the present invention includes: a waveform extracting unit which extracts a partial waveform which is a waveform having a value periodically for each of a plurality of phases from a measured waveform which is a signal from a sensor mounted on equipment which is an object to be diagnosed; a peak detecting unit which detects a peak in a change of the amplitude of the partial waveform with respect to the phase from the partial waveform for each of the plurality of phases which are converted into spectra in a frequency domain; and a diagnosis unit for diagnosing a state of the equipment which is an object to be diagnosed based on a value of the amplitude at the peak.

According to the present invention, it is possible to provide a diagnostic apparatus which can diagnose a deterioration state of equipment which is an object to be diagnosed with high accuracy.

BRIEF DESCRIPTION OF THE DRAWINGS

Fig. 1 is a diagram showing a configurational example of a conventional diagnostic apparatus;

Fig. 2 is a diagram showing a configuration of a diagnostic apparatus according to an embodiment 1 of the present invention;

Fig. 3 is a diagram showing one example of a measured waveform and a periodic window function;

Fig. 4 is a diagram showing one example of a relationship between a phase $\theta$ of the periodic window function and an amplitude of a partial waveform;

Fig. 5 is a diagram showing two peaks on a polar coordinate plane where the phase $\theta$ of the periodic window function and the amplitude of the partial waveform are respectively expressed by angular coordinates and radial coordinates;

Fig. 6 is a diagram showing a configuration of a diagnostic apparatus according to an embodiment 2 of the present invention;

Fig. 7 is a diagram showing a configuration of a diagnostic apparatus according to an embodiment 3 of the present invention;

Fig. 8 is a diagram showing a periodic window function in a diagnostic apparatus according to an embodiment 4 of the present invention;

Fig. 9 is a diagram showing a configuration of a diagnostic apparatus according to an embodiment 5 of the present invention;

Fig. 10 is a diagram showing a configuration of a diagnostic apparatus according to an embodiment 6 of the present invention; and

Fig. 11 is a diagram showing a configuration of a diagnostic apparatus according to an embodiment 7 of the present invention.

## DESCRIPTION OF THE PREFERRED EMBODIMENTS

A diagnostic apparatus according to the present invention can diagnose a deterioration state of equipment which is an object to be diagnosed with high accuracy by taking into account a phase of a signal attributed to a deteriorated part (for example, a part where a scratch or wear occurs) of equipment which is an object to be diagnosed. Such a signal attributed to the deteriorated part of the equipment which is an object to be diagnosed can be obtained based on a signal of a physical quantity which a vibration sensor or a current sensor mounted on the equipment which is an object to be diagnosed measures. As the equipment which is an object to be diagnosed, a rotary machine system can be exemplified.

In this specification, "deteriorated part" indicates, for example, not only a spatial part such as a bearing on a load side of a motor but also a mechanical part such as a part which rotates at a specified rotational frequency. Accordingly, in a diagnosis which uses a vibration sensor, a deteriorated part is expressed including a part which rotates at the same rotational frequency disposed within a range where vibration propagates such as a neighboring part which is mechanically connected to the deteriorated part. In a diagnosis which uses a current sensor, a deteriorated part is expressed including a part which rotates at the same rotational frequency disposed within a range where rotational energy propagates such as a neighboring part which is mechanically connected to the deteriorated part.

It has become apparent from studies which inventors of the present invention have made that an influence of vibration of equipment in a wider range can be measured in a diagnosis which uses a current sensor compared to a diagnosis which uses a vibration sensor. The inventors of the present invention also have found that, for example, when a bearing of the same type is used as a bearing on a non-load side as well as a bearing on a load side of a motor, in a diagnosis which uses a current sensor, influences of vibrations of both bearings are superimposed on a current waveform.

First, a conventional diagnostic apparatus is described.

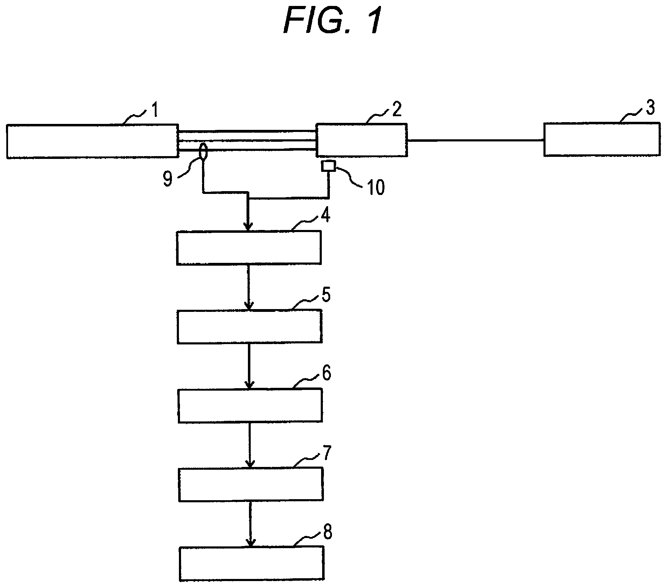

Fig. 1 is a diagram showing a configurational example of the conventional diagnostic apparatus which diagnoses a deterioration state of a rotary machine system based on signals from a vibration sensor and a current sensor.

The rotary machine system includes a power converter 1, a rotary machine 2, and a load device 3. The power converter 1 and the rotary machine 2 are electrically connected to each other. The rotary machine 2 and the load device 3 are mechanically connected to each other. As the mechanical connection method, a method which directly connects a rotary shaft of the rotary machine 2 and a rotary shaft of the load device 3 to each other, or a method which connects the rotary machine 2 and the load device 3 to each other by way of gears, a belt or the like is named. Further, when the gear, the belt or the like is included in an object to be diagnosed, the gear, the belt or the like may be included as the load device.

In the conventional diagnostic apparatus, for example, a measuring unit 4 measures a signal from the vibration sensor 10 or the current sensor 9 and, thereafter, a frequency analyzing unit 5 converts a time sequential waveform of the signal into a spectrum in a frequency domain. An amplitude extracting unit 6 extracts amplitudes at one or two or more characteristic frequencies (frequencies determined corresponding to deterioration) from the spectrum. A diagnosis unit 7 diagnoses a state of equipment which is an object to be diagnosed based on information on amplitudes which the amplitude extracting unit 6 extracts. A display unit 8 displays a diagnosis result from the diagnosis unit 7.

In the conventional diagnostic apparatus, as described above, there arises a drawback that, depending on the positions and the number of deteriorated parts such as scratches, wear or the like corresponding to a rotation phase of the rotary machine system, there may be a case where the degree of abnormality is overestimated or underestimated thus bringing about an erroneous report or omission of a report.

Hereinafter, a diagnostic apparatus according to embodiments of the present invention is described with reference to the drawings. The embodiments described hereinafter are merely one example of a mode for carrying out the present invention and it is not intended that a technical scope of the present invention is limited by the following embodiments.

In the following embodiments, as a method of diagnosing mechanical deterioration, a diagnosis which is performed using a general-purpose vibration sensor or current sensor is described as an example. The diagnostic apparatus according to the present invention can also diagnose a deterioration state of a rotary machine system based on sensing information obtained without using the vibration sensor and the current sensor such as a measured value of a magnetic field sensor or a sound sensor, a value of an internal signal of a power converter (for example, a value of a torque current or a speed feedback) or the like.

In the drawings used in the description of the specification, there may be a case where same symbols are given to identical or corresponding constitutional elements, and the repeated description of these constitutional elements is omitted.

[Embodiment 1]

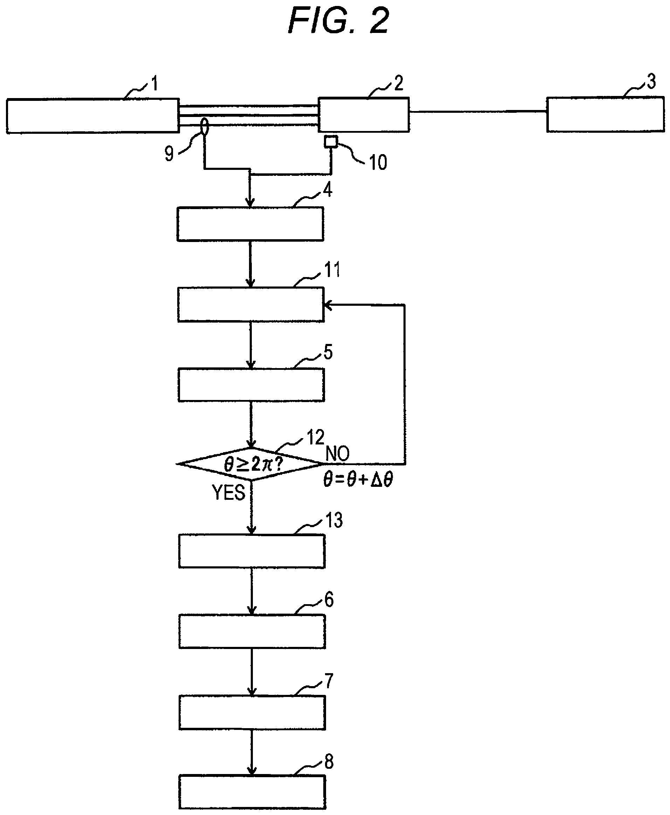

Fig. 2 is a diagram showing a configuration of a diagnostic apparatus 1 according to an embodiment 1 of the present invention. The diagnostic apparatus according to this embodiment diagnoses a deterioration state of a rotary machine system based on a signal transmitted from at least one of the vibration sensor 10 and the current sensor 9. The diagnostic apparatus according to this embodiment can also diagnose a deterioration state of the rotary machine system based on an internal signal of a power converter.

The rotary machine system includes a power converter 1, a rotary machine 2, and a load device 3. The rotary machine system generates a periodic movement such as rotation. The power converter 1 and the rotary machine 2 are electrically connected to each other. The rotary machine 2 and the load device 3 are mechanically connected to each other, are driven by the power converter 1.

Equipment which is object to be diagnosed by the diagnostic apparatus of this embodiment is the rotary machine 2 to which the load device 3 is mechanically connected, the load device 3, and the power converter 1 which controls the rotary machine 2.

The vibration sensor 10 is mounted on the rotary machine 2, and measures vibration of the rotary machine 2. The current sensor 9 is mounted on a line which connects the power converter 1 and the rotary machine 2 to each other, and measures an electric current which flows through the line.

The diagnostic apparatus according to this embodiment includes a measuring unit 4, a waveform extracting unit 11, a frequency analyzing unit 5, a phase difference setting unit 12, a peak detecting unit 13, an amplitude extracting unit 6, a diagnosis unit 7, a display unit 8. The diagnostic apparatus may be formed of a computer, for example. The diagnostic apparatus according to this embodiment is configured such that the waveform extracting unit 11, the phase difference setting unit 12 and the peak detecting unit 13 are added to the conventional diagnostic apparatus (Fig. 1).

The measuring unit 4 measures a signal transmitted from at least one of the vibration sensor 10 and the current sensor 9 (a signal of physical quantity measured by at least one of the sensors 10, 9). The measuring unit 4 can also measure an internal signal of the power converter (for example, a torque current or a speed feedback).

The waveform extracting unit 11 includes a periodic window function having a width L and a period T which are preliminary set (hereinafter, referred to as "periodic window function"). The waveform extracting unit 11 multiplies a signal which is transmitted from the sensor and is measured by the measuring unit 4 (measured waveform) by a periodic window function thus generating a new waveform (partial waveform) having a value periodically. That is, the waveform extracting unit 11 extracts a partial waveform which is a part of a measured waveform and periodically has a zone having a value with a fixed time width L at a period T from the measured waveform using a periodic window function.

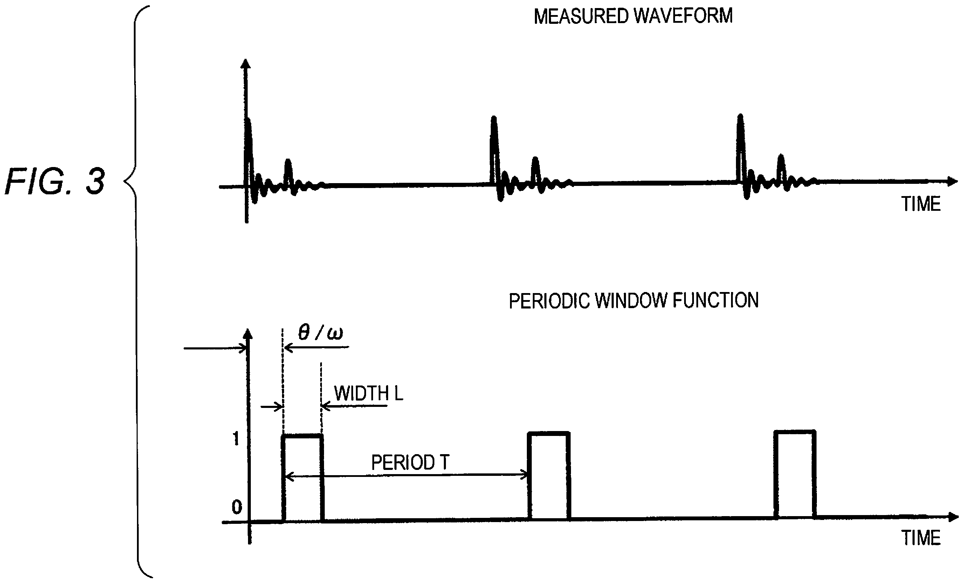

Fig. 3 is a diagram showing one example of a measured waveform and a periodic window function. The measured waveform is shown in an upper part of Fig. 3 and the periodic window function which corresponds to the measured waveform is shown in a lower part of Fig. 3. A measured waveform is a periodic waveform which reflects a periodic movement generated by the rotary machine system. A periodic window function is a periodic window function having a zone of a width L at a period T. The periodic window function takes a value of 1 in the zone of the width L (that is, an amplitude being 1) and takes a value of zero in zones other than the zone of the width L, and the zone of the width L is repeated at the period T. The periodic window function has a phase $\theta$ and an angular frequency $\omega$. The periodic window function is shifted from a measured waveform by the phase $\theta$ (that is, time $\theta/\omega$). The width L of the periodic window function can be appropriately set corresponding to a signal measured by the sensor 9, 10 (measured waveform). The phase $\theta$ of the periodic window function corresponds to a phase of the measured waveform when a periodic partial waveform is extracted from the measured waveform, and an initial value of the phase $\theta$ is zero. The period T of the periodic window function can be determined by taking an inverse number of a target characteristic frequency (a frequency determined corresponding to deterioration). A characteristic frequency is described later.

The configuration of the diagnostic apparatus according to the embodiment 1 of the present invention (Fig. 2) is further described.

The frequency analyzing unit 5 converts a partial waveform (time sequential waveform) which the waveform extracting unit 11 extracts into a spectrum in a frequency domain.

The phase difference setting unit 12 determines whether or not a phase $\theta$ of a periodic window function in the waveform extracting unit 11 is 2n or more. The phase difference setting unit 12 increases the phase $\theta$ by $\Delta\theta$ ($\theta = \theta + \Delta\theta$) when the phase $\theta$ is less than 2n ($\theta < 2n$), and outputs the phase $\theta$ which is increased by $\Delta\theta$ to the waveform extracting unit 11. That is, the phase difference setting unit 12 gradually changes the phase $\theta$ from zero to 2n by an increment $\Delta\theta$. The increment $\Delta\theta$ of the phase $\theta$ can be appropriately determined corresponding to a signal measured by the sensor 9, 10 (measured waveform). When the increment $\Delta\theta$ is large, a quantity of memory necessary for an analysis can be reduced. On the other hand, when the increment $\Delta\theta$ is small, a resolution for detecting a deteriorated part can be increased so that a plurality of deteriorated parts whose positions are close to each other can be more accurately detected by discriminating the deteriorated parts from each other.

When the waveform extracting unit 11 receives a phase $\theta$ ($\theta = \theta + \Delta\theta$) where the phase $\theta$ is increased by $\Delta\theta$ from the phase difference setting unit 12, the waveform extracting unit 11 extracts a partial waveform which periodically has a value with a time width L at a period T from a measured waveform using a periodic window function having the phase $\theta$. That is, using a plurality of periodic window functions which differ from each other in a phase $\theta$, the waveform extracting unit 11 extracts a periodic partial waveform from a measured waveform with respect to each of the plurality of phases $\theta$.

The frequency analyzing unit 5 converts partial waveforms (time sequential waveforms) which the waveform extracting unit 11 extracts with respect to the respective phases $\theta$ ($0 \leq \theta \leq 2\pi$) of a periodic window function into spectra in a frequency domain.

When the phase difference setting unit 12 determines that a phase $\theta$ is 2n or more ($\theta \geq 2n$), the peak detecting unit 13 obtains a relationship of amplitudes (maximum amplitudes) of the partial waveforms with respect to the phases $\theta$ of the periodic window function from spectra which the frequency analyzing unit 5 obtains by converting the partial waveforms at the respective phases $\theta$, and detects peaks in a change of the amplitudes (the distribution of amplitudes) of the partial waveforms with respect to the phases $\theta$. For example, the peak detecting unit 13 can detect a portion where the amplitude is larger than a predetermined threshold value as a peak.

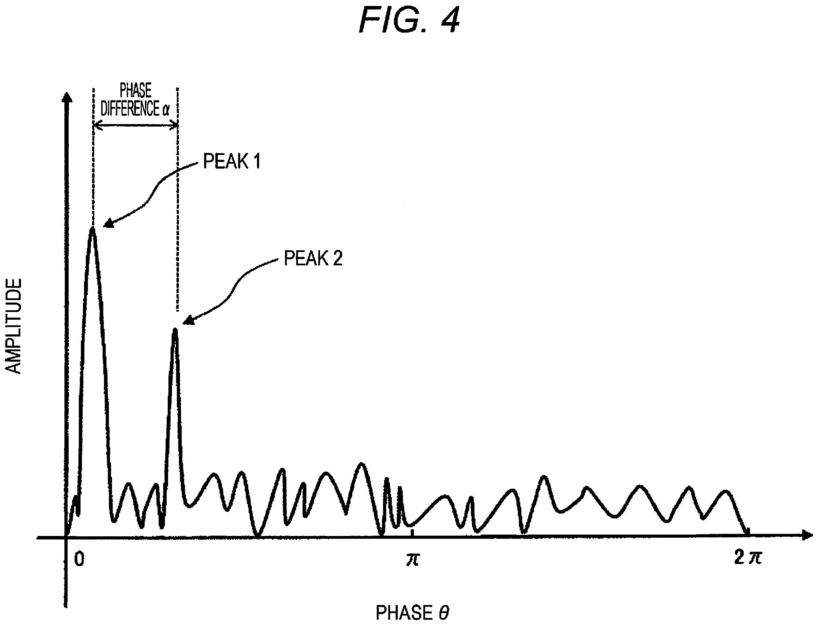

Fig. 4 is a diagram illustrating an example of the relationship between the phase $\theta$ of the periodic window function and the amplitude of the partial waveform obtained by the peak detecting unit 13. When a measured waveform is the waveform shown in the upper part of Fig. 3, the peak detecting unit 13 obtains the waveform shown in Fig. 4 as a relationship between a phase $\theta$ of a periodic window function and an amplitude of a partial waveform. The waveform shown in Fig. 4 has two peaks formed of a peak 1 and a peak 2 with respect to a phase $\theta$. The peak detecting unit 13 detects these two peaks. The peak 1 and the peak 2 are away from each other by a phase difference a. The phase difference $\alpha$ reflects a relative position of a deteriorated part.

A characteristic frequency will be described hereinafter. A characteristic frequency is a frequency of vibration caused by deterioration. The characteristic frequency is determined corresponding to the deterioration.

For example, it is known that a vibration pattern attributed to the mechanical structure of equipment which is an object to be diagnosed (the rotary machine 2) appears in a frequency characteristic of vibration which the vibration sensor 10 measures. The characteristic frequency is the frequency having this vibration pattern. The description is made by taking the deterioration of a bearing of a motor, for example. When the deterioration is a scratch which occurs on an inner ring of a bearing, periodic vibration occurs corresponding to a size of the bearing and the number of bearing balls. The frequency of this vibration is the characteristic frequency.

Also, in the current sensor 9, a characteristic frequency which is expressed by a following equation (1) appears in the measured signal. The deterioration of a bearing, a scratch on a gear or a coupling, abnormality on a load device and the like can be diagnosed using the characteristic frequency.

[Equation 1]

$$f_c = |f_0 \pm f_m| \qquad \cdots (1)$$

In the equation (1), fc is a characteristic frequency of an electric current, $f_0$ is a fundamental frequency of the electric current, and $f_m$ is a frequency of mechanical vibration. For example, assume a case where deterioration is a scratch which occurs on an inner ring of a bearing. In this case, it is known that periodic vibration occurs depending on a size of a bearing, the number of bearing balls or the like, and vibration attributed to the periodic vibration appears as a side band frequency of a fundamental frequency of an electric current. This technique is also referred to as a motor current signature analysis (MCSA).

As a characteristic frequency, a frequency which is obtained in advance by actual measurement may be used. A mechanical vibration frequency obtained based on a geometrical shape of a mechanical part may be used. A mechanical vibration frequency determined based on a product model number of a mechanical part may be used.

Table 1 is a table which indicates one example of characteristic frequency of vibration measured by the vibration sensor 10. Table 1 indicates characteristic frequencies which correspond to deteriorated parts of a bearing of a motor when the bearing of the motor is deteriorated. In Table 1, fr is rotational frequency of the bearing of the motor, $n_b$ is the number of balls, bd is a diameter of the ball, pd is a pitch diameter, and $\beta$ is a contact angle.

[Table 1]

| Deteriorated part | Characteristic frequency |
|---|---|
| Retainer | $\dfrac{f_r}{2}\left(1-\dfrac{bd}{pd}\cos\beta\right)$ |
| Scratch on outer ring | $n_b\dfrac{f_r}{2}\left(1-\dfrac{bd}{pd}\cos\beta\right)$ |
| Scratch on inner ring | $n_b\dfrac{f_r}{2}\left(1+\dfrac{bd}{pd}\cos\beta\right)$ |
| Ball | $\dfrac{pd}{bd}\dfrac{f_r}{2}\left\{1-\left(\dfrac{bd}{pd}\cos\beta\right)^2\right\}$ |

The diagnostic apparatus according to this embodiment may use one characteristic frequency, or may use a plurality of characteristic frequencies. A higher-order component may be added to a characteristic frequency. By using a plurality of characteristic frequencies, it is possible to take into account a plurality of deteriorated parts or a plurality of types of deterioration (scratch and wear).

Such a frequency analyzing technique is applicable to a phenomenon where information attributed to deterioration is superimposed periodically. Information attributed to deterioration is not limited to a value of vibration, an electric current, and an internal signal of a power converter (for example, a value of a torque current or speed feedback) and the like. For example, in an apparatus where a temperature and a pressure are controlled to fixed values, assume that abnormality occurs so that a periodic disturbance is applied to the apparatus and a change in temperature or pressure is observed. In this case, although only a DC current value is outputted in a normal state, a periodic disturbance attributed to abnormality is observed as a change in temperature or a change in pressure of a specified frequency component. By detecting the increase in this frequency component (characteristic frequency), a progress of abnormality can be detected in an initial stage in a system where a temperature and a pressure are controlled to fixed values originally.

The configuration of the diagnostic apparatus according to the embodiment 1 of the present invention (Fig. 2) is further described.

The amplitude extracting unit 6 acquires information on the number of peaks in a change of an amplitude of a partial waveform, phases $\theta$ at which the peaks are given, and values of amplitudes at the peaks based on a relationship (Fig. 4) between a phase $\theta$ of a periodic window function and the amplitudes of the partial waveform which the peak detecting unit 13 obtains. The amplitude extracting unit 6 can obtain the number of peaks, phases $\theta$ at which the peaks are given, and values of amplitudes at the peaks using, for example, a conventional technique. In the example shown in Fig. 4, the amplitude extracting unit 6 obtains two peaks, the phases $\theta$ at which the respective peaks are given, and the values of the amplitudes at the respective peaks.

The amplitude extracting unit 6 stores the number of peaks, the phases θ at which the peaks are given, and the values of the amplitudes at the peaks. When the amplitude extracting unit 6 acquires a plurality of peaks, the amplitude extracting unit 6 stores the peaks together with the phase differences α of the peaks. Accordingly, the amplitude extracting unit 6 can follow a change with time of individual components of vibration and hence, the amplitude extracting unit 6 can monitor a change in state of equipment which is an object to be diagnosed.

The features of the diagnosis by the diagnostic apparatus according to this embodiment and drawbacks of the diagnosis by a conventional diagnostic apparatus are described using a diagram where two peaks having the amplitudes indicated in Fig. 4 are projected on a polar coordinate plane.

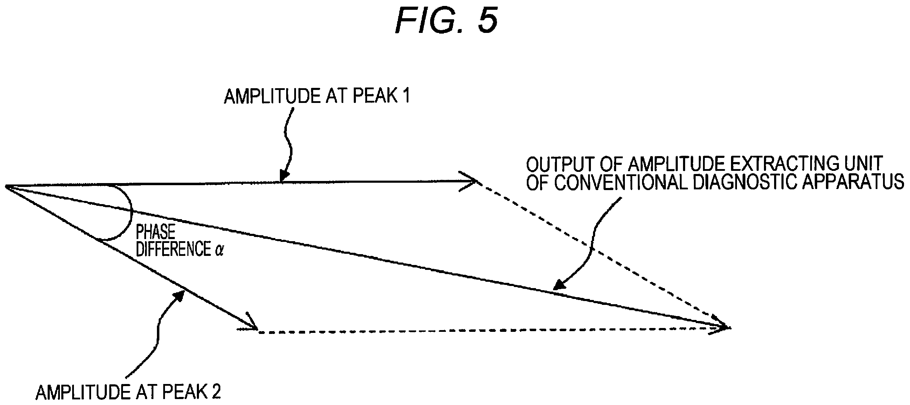

Fig. 5 is a diagram showing the peak 1 and the peak 2 shown in Fig. 4 on a polar coordinate plane where the phase θ of the periodic window function and the amplitudes of the partial waveforms shown in Fig. 4 are respectively expressed by angular coordinates and radial coordinates. In Fig. 5, an angle made by the amplitude at the peak 1 and the amplitude at the peak 2 is a phase difference α between these peaks.

In the diagnostic apparatus according to this embodiment, a plurality of peaks having different phases θ such as the peak 1 and the peak 2 are detected separately from each other, and the amplitudes at respective peaks can be obtained.

In the conventional diagnostic apparatus, a composite component of the amplitude at the peak 1 and the amplitude at the peak 2 is obtained as an output of the amplitude extracting unit 6. That is, in the conventional diagnostic apparatus, the influences of the components of a plurality of peaks are overestimated or underestimated depending on the magnitude of the phase difference a. Specifically, when an absolute value of the phase difference α is small, a composite component of the amplitude at the peak 1 and the amplitude at the peak 2 becomes larger than the amplitude at the peak 1 and the amplitude at the peak 2. Accordingly, a degree of abnormality is overestimated. On the other hand, when the absolute value of the phase difference α is close to n, a composite component of the amplitude at the peak 1 and the amplitude at the peak 2 becomes smaller than the amplitude at the peak 1 and the amplitude at the peak 2. Accordingly, a degree of abnormality is underestimated. In the conventional diagnostic apparatus, the degree of abnormality is underestimated or overestimated. Accordingly, there is a possibility that an erroneous report or the omission of a report occurs.

In the diagnostic apparatus according to this embodiment, the plurality of peaks which differ from each other in phase θ are detected separately from each other, and the amplitudes at the respective peaks are obtained. As a result, the influence of the components of the respective peaks can be accurately evaluated and the degree of abnormality can be accurately evaluated. Accordingly, there is no possibility that an erroneous report or the omission of a report occurs. The diagnostic apparatus according to this embodiment can diagnose a deterioration state of equipment which is an object to be diagnosed with high accuracy in this manner.

The configuration of the diagnostic apparatus according to the embodiment 1 of the present invention (Fig. 2) is further described.

Based on the amplitude value at the peak of the change in the amplitude of the partial waveform with respect to the phase θ of the periodic window function obtained by the amplitude extracting unit 6, the diagnosis unit 7 uses the conventional method to determine the state of the equipment which is an object to be diagnosed. For example, when a value of the amplitude at a peak which the amplitude extracting unit 6 obtains is larger than a preset threshold value, the diagnosis unit 7 can determine that equipment which is an object to be diagnosed is abnormal and is deteriorated. Further, for example, in the case where a value of an amplitude at a peak which the amplitude extracting unit 6 obtains changes with time and becomes larger than a preset threshold value or when the value of the amplitude at the peak goes beyond a normal state which is preliminarily learned through machine leaning, the diagnosis unit 7 can determine that equipment which is an object to be diagnosed is abnormal.

The display unit 8 notifies a user of a diagnosis result from the diagnosis unit 7 by displaying the diagnosis result. The display unit 8 notifies the user of a diagnosis result by, for example, displaying the diagnosis result on a display, turning on a lamp, or sending an e-mail.

[Embodiment 2]

A diagnostic apparatus according to the embodiment 2 of the present invention will be described. Hereinafter, points which make a diagnostic apparatus of this embodiment differ from the diagnostic apparatus of the embodiment 1 are described.

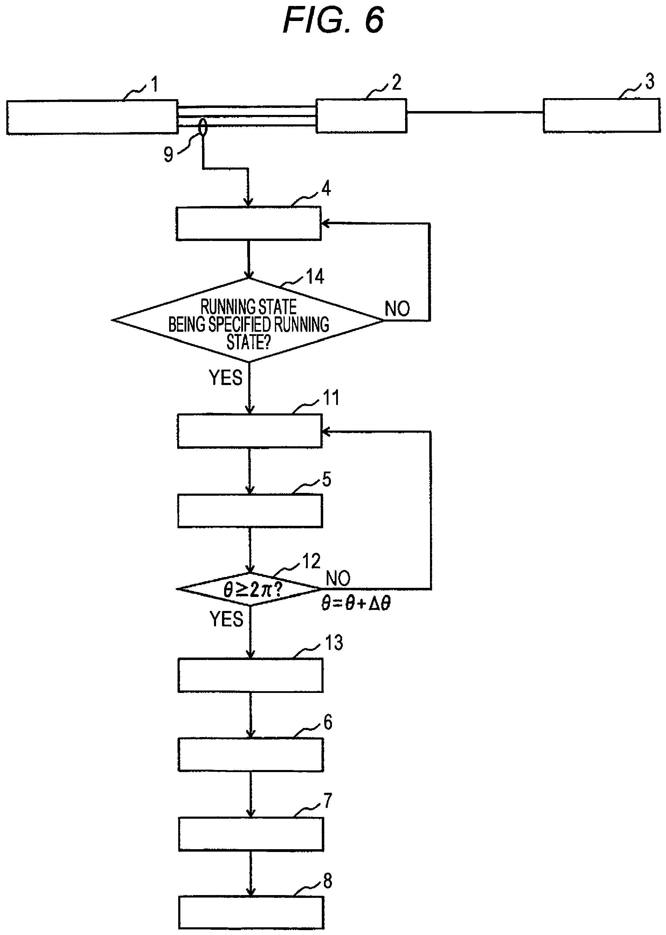

Fig. 6 is a diagram illustrating the configuration of the diagnostic apparatus according to this embodiment. The diagnostic apparatus according to this embodiment differs from the diagnostic apparatus according to the embodiment 1 with respect to the point that the diagnostic apparatus according to this embodiment further includes a specific state extracting unit 14. The diagnostic apparatus according to this embodiment diagnoses a deterioration state of a rotary machine system based on a signal from a current sensor 9.

In the diagnostic apparatus according to the embodiment 1, the waveform extracting unit 11 generates a periodic partial waveform from a signal (a measured waveform) from the sensor which the measuring unit 4 measures regardless of a running state of the rotary machine system to be diagnosed. In order to improve diagnostic accuracy, it is desirable that the diagnostic apparatus uses only measurement data of a specified running state which is preliminarily set.

The diagnostic apparatus according to this embodiment includes the specific state extracting unit 14 which determines whether or not a running state of the rotary machine system to be diagnosed is a specified running state which is preliminarily set. The specified running state can be determined appropriately, and may be a running state under no load at a fixed speed, for example.

The specific state extracting unit 14 obtains a running state of the rotary machine system, and outputs a signal (measured waveform) from a sensor which a measuring unit 4 measures to the waveform extracting unit 11 when the obtained running state is a specified running state which is preliminarily set. Any method can be used in determining whether or not a running state of the rotary machine system is a specified running state. For example, a method can be used where the transition of an effective value of an electric current is obtained, and a waveform which is shifted by a specified length within a range of the specified effective value is extracted, and a specified running state is determined using the extracted waveform.

Fig. 6 shows an example where the specific state extracting unit 14 converts a signal from the current sensor 9 into an effective value. The specific state extracting unit 14 may adopt a running state at a specified rotational frequency obtained by a frequency analysis as a specified running state. Further, the specific state extracting unit 14 may receive inputting of signals from sensors which are not used for diagnosis (for example, a signal from a vibration sensor, a signal from a rotation speed sensor, or a signal indicating a manufacturing condition), and may obtain a running state of the rotary machine system using these signals.

[Embodiment 3]

A diagnostic apparatus according to an embodiment 3 of the present invention will be described. Hereinafter, points which make a diagnostic apparatus of this embodiment differ from the diagnostic apparatus of the embodiment 1 are described.

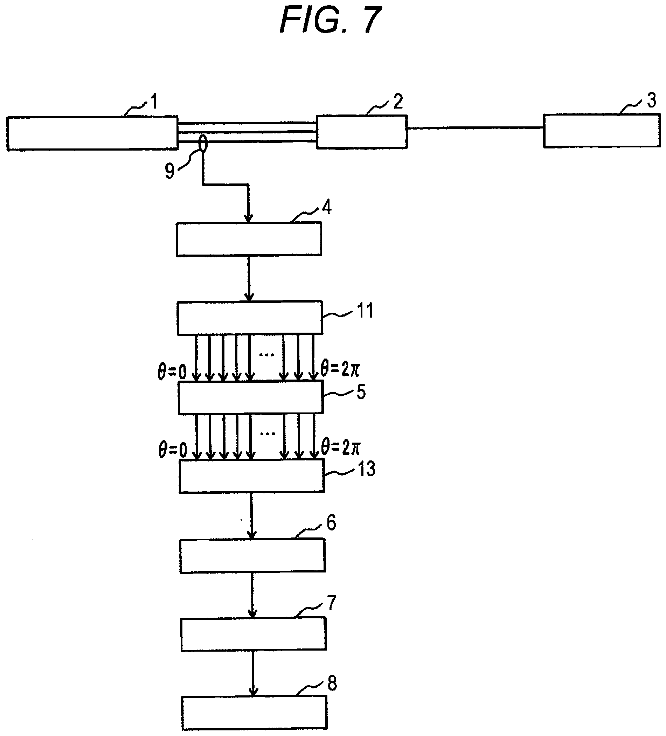

Fig. 7 is a diagram illustrating the configuration of the diagnostic apparatus according to this embodiment. The diagnostic apparatus according to this embodiment differs from the diagnostic apparatus according to the embodiment 1 with respect to the following points. The diagnostic apparatus according to this embodiment does not include a phase difference setting unit 12. A waveform extracting unit 11 includes a plurality of periodic window functions having different phases $\theta$. The waveform extracting unit 11 includes a plurality of periodic window functions where the phase $\theta$ takes any value from zero to 2n. The diagnostic apparatus according to this embodiment diagnoses a deterioration state of a rotary machine system based on a signal from a current sensor 9.

In the diagnostic apparatus according to the embodiment 1 (Fig. 2), the phase difference setting unit 12 changes a phase $\theta$ of a periodic window function from zero to 2n by an iterative loop. The waveform extracting unit 11 extracts a periodic partial waveform from a measured waveform using a periodic window function having a phase $\theta$ changed by the phase difference setting unit 12. The frequency analyzing unit 5 converts the partial waveform into a spectrum in a frequency domain with respect to each phase $\theta$.

In the diagnostic apparatus according to this embodiment, the waveform extracting unit 11 has a plurality of periodic window functions having different phases $\theta$ preliminarily, extracts periodic partial waveforms from measured waveforms using the respective periodic window functions, and the frequency analyzing unit 5 converts the partial waveforms into spectra in frequency domains with respect to the respective phases $\theta$.

Since the diagnostic apparatus according to this embodiment does not include the phase difference setting unit 12, and does not execute iterative loop processing where the phase $\theta$ of the periodic window function is changed from zero to 2n. Accordingly, a speed of analysis can be enhanced. In the diagnostic apparatus according to this embodiment, a consumed quantity of memory is increased compared to the diagnostic apparatus of the embodiment 1. Accordingly, by taking into account a required analysis speed, a user can select either the configuration of the diagnostic apparatus according to this embodiment or the configuration of the diagnostic apparatus according to the embodiment 1.

[Embodiment 4]

A diagnostic apparatus according to an embodiment 4 of the present invention will be described. Hereinafter, points which make a diagnostic apparatus of this embodiment differ from the diagnostic apparatus of the embodiment 1 are described.

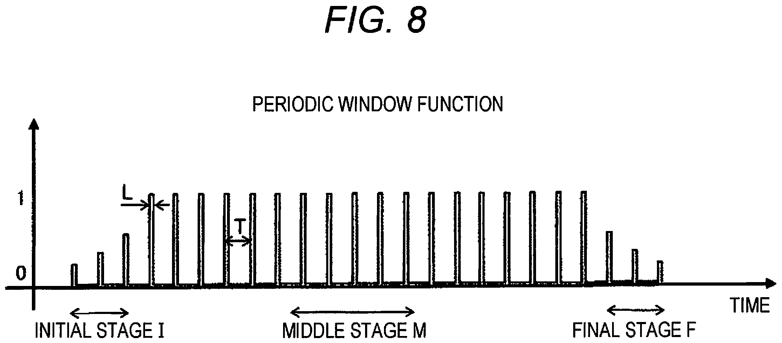

Fig. 8 is a diagram illustrating a periodic window function which the waveform extracting unit 11 of the diagnostic apparatus according to this embodiment includes. In the periodic window function, a zone of a width L having a value is repeated at a period T, and the repetition of the zone of the width L is performed in an initial stage I, in a middle stage M and in a final stage F. The initial stage I is a time range at the beginning of the periodic window function, the final stage F is a time range at the end of the periodic window function, and the middle stage M is the time range between the initial stage I and the final stage F.

In the embodiment 1, a value of a periodic window function (that is, an amplitude) in the zone having the width L is fixed with respect to time (the lower part of Fig. 3).

In this embodiment, the value (amplitude) of the periodic window function in the zone having the width L is not constant with respect to time, and the value (amplitude) of the periodic window function in at least one of the initial stage I and the final stage F is smaller than the value (amplitude) in the middle stage M. In the periodic window function shown in Fig. 8, the amplitude in both the initial stage I and the final stage F is smaller than the amplitude in the middle stage M. Accordingly, in the periodic window function shown in Fig. 8, although the periodic partial waveforms are extracted from the measured waveform, the partial waveforms are extracted in a state where the amplitude of the waveform is contracted in the initial stage I and the final stage F.

As a kind of such window function, a Gaussian window, a Hann window, a Hamming window or the like, for example, can be named. The waveform extracting unit 11 can have a periodic window function which uses such a window function corresponding to accuracy of diagnosis.

By using the periodic window function described in this embodiment, the influence of the measured waveforms in a specified time range (at least one of the initial stage I and the final stage F) can be reduced and hence, a deterioration state of equipment which is an object to be diagnosed can be diagnosed with high accuracy.

[Embodiment 5]

A diagnostic apparatus according to an embodiment 5 of the present invention will be described. Hereinafter, points which make a diagnostic apparatus of this embodiment differ from the diagnostic apparatus of the embodiment 1 are described.

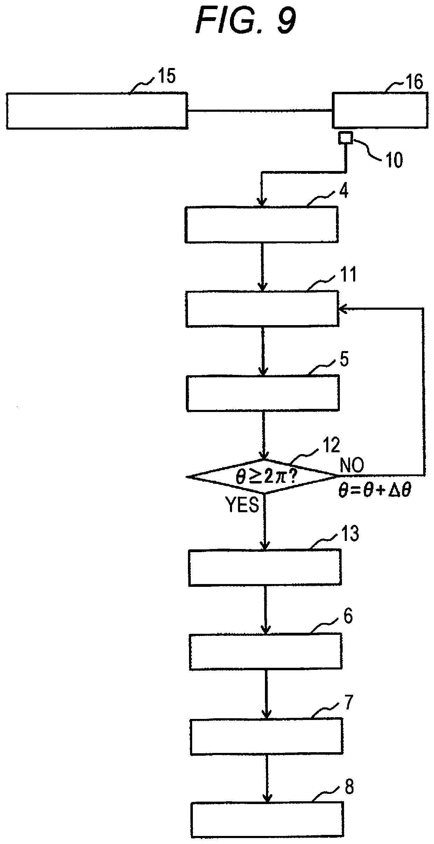

Fig. 9 is a diagram illustrating a configuration of a diagnostic apparatus according to this embodiment. In the diagnostic apparatus according to the embodiment 1, the rotary machine 2, the load device 3, and the power converter 1 of the rotary machine system are equipment which is an object to be diagnosed. In the diagnostic apparatus according to this embodiment, a controller 15 and a mechanical device 16 of a rotary machine system are equipment which is an object to be diagnosed. The diagnostic apparatus according to this embodiment diagnoses a deterioration state of the rotary machine system based on a signal transmitted from a vibration sensor 10 mounted on the mechanical device 16.

The mechanical device 16 is any mechanical device controlled by the controller 15. The controller 15 is a device which controls the mechanical device 16, and also includes a device which controls the mechanical device 16 by supplying energy constantly or periodically. As an example of the combination of the mechanical device 16 and the controller 15, the combination of a generator and an energy supply source which supplies energy to the generator, the combination of a gas turbine and a controller which controls the gas turbine, the combination of a mechanical device which repeats the same operation and an energy source which supplies energy to the mechanical device and the like are named.

Fig. 9 shows the diagnostic apparatus which diagnoses a deterioration state of the rotary machine system based on a signal transmitted from the vibration sensor 10. However, the diagnostic apparatus according to this embodiment can diagnoses the deterioration state based on a signal transmitted from a current sensor or other sensor. Also in this case, it is possible to acquire advantageous effects substantially equal to the advantageous effects acquired by the diagnostic apparatus according to the embodiment 1.

[Embodiment 6]

A diagnostic apparatus according to an embodiment 6 of the present invention will be described. Hereinafter, points which make a diagnostic apparatus of this embodiment differ from the diagnostic apparatus of the embodiment 1 are described.

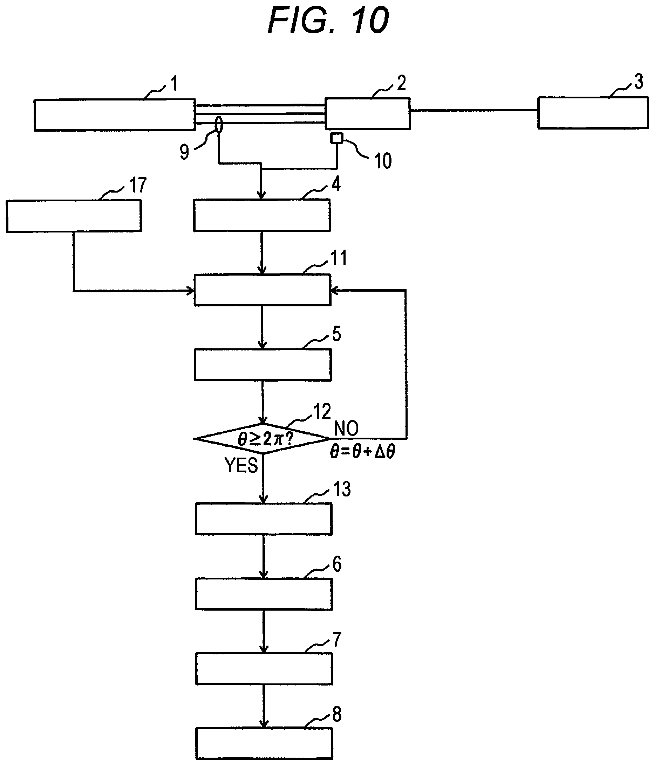

Fig. 10 is a diagram showing the configuration of a diagnostic apparatus according to this embodiment. The diagnostic apparatus according to this embodiment differs from the diagnostic apparatus according to the embodiment 1 with respect to a point that the diagnostic apparatus includes a system information inputting unit 17.

The system information inputting unit 17 is an inputting device which allows a user of the diagnostic apparatus to set a periodic window function. In the system information inputting unit 17, a periodic window function is inputted by a user, and the inputted periodic window function is outputted to a waveform extracting unit 11. The waveform extracting unit 11 extracts periodic partial waveforms from a measured waveform using the periodic window function received from the system information inputting unit 17. The system information inputting unit 17 inputs, for example, parameters which set a periodic window function such as a width L, a period T, an increment $\Delta\theta$ of a phase $\theta$ and the like, and a characteristic frequency used for diagnosis. The system information inputting unit 17 also can output a periodic window function determined based on the inputted information to the waveform extracting unit 11.

In the diagnostic apparatus according to this embodiment, since the periodic window function is set by the user, diagnosis can be performed with higher accuracy using any periodic window function.

[Embodiment 7]

A diagnostic apparatus according to an embodiment 7 of the present invention will be described. Hereinafter, points which make a diagnostic apparatus of this embodiment differ from the diagnostic apparatus of the embodiment 1 are described.

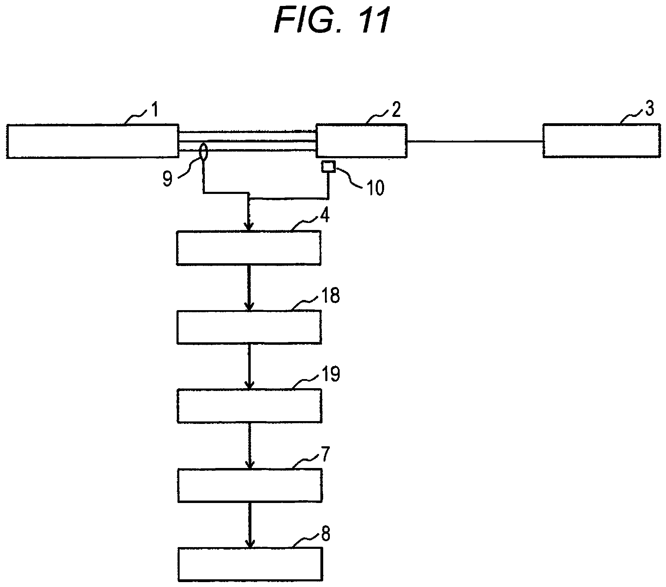

Fig. 11 is a diagram illustrating a configuration of a diagnostic apparatus according to this embodiment. The diagnostic apparatus according to this embodiment differs from the diagnostic apparatus according to the embodiment 1 with respect to the following points. The diagnostic apparatus according to this embodiment includes none of a waveform extracting unit 11, a frequency analyzing unit 5, a phase difference setting unit 12, a peak detecting unit 13, and an amplitude extracting unit 6. On the other hand, the diagnostic apparatus according to this embodiment includes: a waveform dividing unit 18 for dividing a waveform into periodic components; and a periodic amplitude extracting unit 19 having periodicity.

The waveform dividing unit 18 for dividing a waveform into periodic components divides a measured waveform (shown in the upper part of Fig. 3) into respective predetermined periods Ta. The period Ta can be determined in the same manner as the period T of the periodic window function described in the embodiment 1. The waveform dividing unit 18 for dividing the waveform into periodic components outputs each of the divided measured waveforms to the periodic amplitude extracting unit 19.

The periodic amplitude extracting unit 19 receives the divided measured waveform from the waveform dividing unit 18 for dividing a waveform into periodic components, and checks whether or not the divided measured waveforms have periodicity by any conventional method. If there is periodicity between the divided measured waveforms, the periodicity amplitude extracting unit 19 obtains information on peaks included in the divided measured waveforms (for example, the number of peaks, values of amplitudes at the peaks), and outputs the obtained information on the peaks to the diagnosis unit 7 without performing a frequency analysis.

The diagnosis unit 7 diagnoses a state of the equipment which is an object to be diagnosed using a conventional method based on the information on the peaks received from the periodic amplitude extracting unit 19.

The diagnostic apparatus according to this embodiment performs diagnosis based on the information on the periodic peaks included in the measured waveform, and does not require a frequency analysis. Accordingly, the diagnostic apparatus according to this embodiment can perform diagnosis with a smaller quantity of memory than the diagnostic apparatus according to the embodiment 1.

It should be noted that the present invention is not limited to the above-mentioned embodiments, and various modifications are possible. For example, the above embodiments have been described in detail in order to easily describe the present invention, and the present invention is not necessarily limited to a mode having all the described configurations. In addition, a part of the configuration of one embodiment can be replaced with the configuration of another embodiment. It is also possible to add the configuration of one embodiment to the configuration of another embodiment. Further, a part of the configuration of each embodiment can be deleted, or another configuration can be added or replaced with respect to parts of the configuration of the respective embodiments.

**Claims**

1.  A diagnostic apparatus comprising:

    a waveform extracting unit (11) which extracts a partial waveform which is a waveform having a value periodically for each of a plurality of phases from a measured waveform which is a signal from a sensor mounted on equipment which is an object to be diagnosed;
    a peak detecting unit which detects a peak in a change of the amplitude of the partial waveform with respect to the phase from the partial waveform for each of the plurality of phases which are converted into spectra in a frequency domain; and
    a diagnosis unit (7) for diagnosing a state of the equipment to be diagnosed based on a value of the amplitude at the peak.

2.  The diagnostic apparatus according to claim 1, wherein the waveform extracting unit (11) extracts the partial waveform from the measured waveform with respect to each of the plurality of phases using a plurality of periodic window functions having different phases from each other.

3. The diagnostic apparatus according to claim 1, wherein the waveform extracting unit (11) extracts the partial waveform from the measured waveform which is the signal from at least one of a vibration sensor (10) and a current sensor (9).

4. The diagnostic apparatus according to claim 1, wherein the waveform extracting unit (11) extracts the partial waveform from the measured waveform which is an internal signal of a power converter (1) which controls a rotary machine (2).

5. The diagnostic apparatus according to claim 2, wherein, in the periodic window function, the amplitude in at least one of a start time range and an end time range is smaller than the amplitude in a time range between the start time range and the end time range.

6. The diagnostic apparatus according to claim 2, further comprising an information inputting unit (17) through which a parameter for determining the periodic window function is inputted.

7. A diagnostic apparatus comprising:

a waveform dividing unit (18) which divides a measured waveform being a signal from a sensor mounted on equipment which is an object to be diagnosed for each period preliminarily set;
an amplitude extracting unit (6) which obtains information on a peak included in a waveform obtained by division by the waveform dividing unit (18); and
a diagnosis unit (7) for diagnosing the state of the equipment which is an object to be diagnosed based on the information on the peak.

EP 3 719 514 A1

# FIG. 1

# FIG. 2

FIG. 3

MEASURED WAVEFORM

TIME

PERIODIC WINDOW FUNCTION

$\theta / \omega$

WIDTH L

1

PERIOD T

0

TIME

FIG. 4

## FIG. 5

AMPLITUDE AT PEAK 1

OUTPUT OF AMPLITUDE EXTRACTING UNIT
OF CONVENTIONAL DIAGNOSTIC APPARATUS

PHASE
DIFFERENCE α

AMPLITUDE AT PEAK 2

EP 3 719 514 A1

# FIG. 6

# FIG. 7

$\theta=0 \qquad \theta=2\pi$

$\theta=0 \qquad \theta=2\pi$

FIG. 8

# FIG. 9

# FIG. 10

# FIG. 11

Europäisches
Patentamt

European
Patent Office

Office européen
des brevets

# EUROPEAN SEARCH REPORT

Application Number

EP 20 15 7594

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/033695 A1 (SAHARA JUNTARO [JP] ET AL) 7 February 2008 (2008-02-07) | 1-6 | INV.<br>G01R31/34<br>G01R19/25 |
| A | * figure 24 *<br>* paragraph [0001] *<br>* paragraph [0293] - paragraph [0337] * | 7 | |
| X | US 2012/265457 A1 (DONOLO MARCOS A [US]) 18 October 2012 (2012-10-18) | 1-6 | |
| A | * figure 4 *<br>* paragraph [0002] *<br>* paragraph [0027] - paragraph [0033] * | 7 | |
| X | CN 108 983 097 A (BEIJING ETECHWIN ELECTRICAL CO LTD) 11 December 2018 (2018-12-11) | 1-6 | |
| A | * paragraph [0065] - paragraph [0069] * | 7 | |
| X | US 2013/253850 A1 (AULANKO ANTTI SAKARI [FI]) 26 September 2013 (2013-09-26) | 1-6 | |
| A | * figure 1 *<br>* paragraph [0029] - paragraph [0037] * | 7 | TECHNICAL FIELDS SEARCHED (IPC) |
| X | US 2017/307689 A1 (MURAMATSU TOSHIFUMI [JP]) 26 October 2017 (2017-10-26)<br>* figures 2A-C *<br>* figure 4 *<br>* paragraph [0048] - paragraph [0053] * | 7 | G01R<br>H02K<br>G01M<br>G01H |
| X | JP H10 281859 A (MITSUI SHIPBUILDING ENG) 23 October 1998 (1998-10-23)<br>* paragraph [0015] - paragraph [0016] * | 7 | |

The present search report has been drawn up for all claims

| Place of search | Date of completion of the search | Examiner |
|---|---|---|
| Munich | 26 August 2020 | Nguyen, Minh |

EPO FORM 1503 03.82 (P04C01)

## ANNEX TO THE EUROPEAN SEARCH REPORT
## ON EUROPEAN PATENT APPLICATION NO.

EP 20 15 7594

This annex lists the patent family members relating to the patent documents cited in  the above-mentioned European search report.
The members are as contained in the European Patent Office EDP file on
The European Patent Office is in no way liable for these particulars which are merely given for the purpose of information.

26-08-2020

| Patent document cited in search report | | Publication date | Patent family member(s) | | Publication date |
|---|---|---|---|---|---|
| US 2008033695 | A1 | 07-02-2008 | US 2008033695 A1 | | 07-02-2008 |
| | | | WO 2006043511 A1 | | 27-04-2006 |
| US 2012265457 | A1 | 18-10-2012 | NONE | | |
| CN 108983097 | A | 11-12-2018 | NONE | | |
| US 2013253850 | A1 | 26-09-2013 | BR 112012023665 A2 | | 24-09-2019 |
| | | | CN 102893136 A | | 23-01-2013 |
| | | | EP 2547991 A1 | | 23-01-2013 |
| | | | US 2013253850 A1 | | 26-09-2013 |
| | | | WO 2011114006 A1 | | 22-09-2011 |
| US 2017307689 | A1 | 26-10-2017 | CN 107305157 A | | 31-10-2017 |
| | | | DE 102017003831 A1 | | 26-10-2017 |
| | | | JP 6499611 B2 | | 10-04-2019 |
| | | | JP 2017194368 A | | 26-10-2017 |
| | | | US 2017307689 A1 | | 26-10-2017 |
| JP H10281859 | A | 23-10-1998 | NONE | | |

EPO FORM P0459

For more details about this annex : see Official Journal of the European Patent Office, No. 12/82

**EP 3 719 514 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017194368 A